# EUROPÄISCHE PATENTSCHRIFT

(11) **EP 4 643 613 B1**
(45) Veröffentlichungstag und Bekanntmachung des Hinweises auf die Patenterteilung: **11.11.2026**
(21) Anmeldenummer: 23825474.2
(22) Anmeldetag: 07.12.2023
(51) Int. Cl.: H05K 7/14

(54) **BEFESTIGUNGSVORRICHTUNG ZUR BEFESTIGUNG EINER ELEKTRONISCHEN KOMPONENTE**
FASTENING DEVICE FOR FASTENING AN ELECTRONIC COMPONENT
DISPOSITIF DE FIXATION POUR FIXER UN COMPOSANT ÉLECTRONIQUE

(30) Priorität: 27.12.2022 AT 2342022
(43) Veröffentlichungstag der Anmeldung: 05.11.2025
(73) Patentinhaber: Patchbox GmbH, 1200 Wien (AT)
(72) Erfinder: GENG, Alexander, 1090 Wien (AT); HOFSTÄTTER, Josef, 1140 Wien (AT)
(74) Vertreter: SONN Patentanwälte GmbH & Co KG
(86) Internationale Anmeldenummer: PCT/IB2023/062355
(87) Internationale Veröffentlichungsnummer: WO 2024/141836

(56) Entgegenhaltungen:
- US-A- 6 095 345
- US-A1- 2012 104 200
- US-A1- 2019 390 701

## Beschreibung

Die Erfindung betrifft ein Gestell zur Aufbewahrung von elektronischen Komponenten, umfassend wenigstens zwei in Abstand voneinander angeordnete, senkrecht verlaufende und eine Lochreihe aufweisende Blechwinkel, deren zueinander weisende erste Schenkel eine Öffnung begrenzen und an denen wenigstens eine elektronische Komponente befestigt ist, wobei die elektronische Komponente im Wesentlichen eine der Öffnung entsprechende Breite und wenigstens zwei an einer Vorderseite an ihren Rändern nach außen vorspringende, mit der Vorderseite vorzugsweise fluchtende Befestigungslaschen aufweist, welche an den ersten Schenkeln anliegend angeordnet sind und mit Löchern der Lochreihe fluchtende Löcher aufweisen, und wobei an den ersten Schenkeln jeweils eine Befestigungsvorrichtung befestigt ist mit einer an eine Seitenwand der Komponente anlegbaren und ggf. mit dieser verbindbaren Platte, welche einen entlang einer Biegelinie umgebogenen Befestigungsabschnitt aufweist, welcher wenigstens einen sich von der Platte weg erstreckenden, das Loch der Befestigungslasche und ggf. der Lochreihe durchsetzenden ersten Befestigungsbolzen aufweist und wobei die Komponente formschlüssig gegen die Schwerkraft abgestützt ist.

Die Veröffentlichungen US 6,095,345 A, US 2012/104200 A1 sowie US 2019/390701 A1 offenbaren Gestelle mit Bezug zum Gegenstand der vorliegenden Erfindung.

Unter dem Begriff Gestell ist im Zusammenhang mit der vorliegenden Erfindung und entsprechend dem fachlichen Sprachgebrauch ein Rack für elektronische Komponenten mit einer genormten Breite von z.B. 19 Zoll zu verstehen, bei dem die einzelnen Komponenten, die sich im Gestell montieren lassen, eine der genormten Breite entsprechende Breite von z.B. 19 Zoll aufweisen. In Höhenrichtung ist ein derartiges Rack üblicherweise in genormte Höheneinheiten unterteilt, wodurch wiederum die Mindesthöhe einer zu montierenden Komponente festlegt wird. Die im Gestell zu befestigenden elektronischen Komponenten haben demgemäß zumeist eine standardisierte Höhe von einer Höheneinheit oder einem Vielfachen davon. Eine Höheneinheit (HE) eines Standard 19 Zoll Gestells besitzt eine Höhe von 1,75 Zoll.

Die mit der Befestigungsvorrichtung zu befestigenden elektronischen Komponenten weisen seitlich vorstehende plattenförmige Befestigungslaschen auf, mittels welcher eine Befestigung an den Lochreihen an der Vorderseite des Gestells verlaufender Blechwinkel erfolgt. Die plattenförmigen Befestigungslaschen der elektronischen Komponente sind in ihren seitlich vorstehenden Bereichen mit Löchern versehen, die in einer mit der Lochreihe der Blechwinkel fluchtenden Position der Aufnahme von Verbindungsmitteln, insbesondere Schraubbolzen dienen. Die Blechwinkel können etwa 2 mm stark sein und sind im Falle genormter 19 Zoll Gestelle je 15,88 mm breit und bilden zwischen sich eine etwa 19 Zoll breite Öffnung aus. Pro Höheneinheit liegen meist drei Löcher in Abständen von jeweils 0,655 Zoll übereinander.

Die Montage von elektronischen Komponenten in Gestellen ist aufwendig und gestaltet sich meist schwierig, da die elektronischen Komponenten ein gewisses Gewicht sowie eine gewisse Sperrigkeit aufweisen.

Die Montage von elektronischen Komponenten erfolgt meist an der Vorderseite des Gestells, also dort, wo die mit der Lochreihe versehenen senkrecht verlaufenden Blechwinkel angeordnet sind.

Die Löcher der Lochreihe können als runde Löcher bei sog. "Round-hole Racks" oder als quadratische Löcher bei sog. "Square-hole Racks" ausgebildet sein bzw. sind bei sog. "Threaded-hole Racks" mit Gewinden versehen.

Da Gestelle der herkömmlichen Art keine Auflagefläche zum Aufsetzen der elektronischen Komponenten bieten, muss der Monteur die elektronische Komponente händisch in eine Position bringen, in der die Löcher an den seitlich vorstehenden Bereichen der plattenförmigen Befestigungslaschen mit den Löchern der Lochreihe der Blechwinkel fluchten, die Komponente in dieser Position halten und die Verbindungsschrauben anbringen, um die Komponente im Gestell zu fixieren. Dabei muss der Monteur die elektronische Komponente entweder selbst in der korrekten Position halten, sodass zur Befestigung der Komponente nur eine freie Hand zur Verfügung steht, oder die Montage muss zu zweit durchgeführt werden, wobei einer der Beteiligten die Komponente in der korrekten Montageposition hält und der andere die Montage vornimmt.

Alternativ kann die Montage von elektronischen Komponenten auch an der meist ebenfalls mit Lochreihen versehenen Rückseite des Gestells erfolgen.

Auf Grund der oben genannten Unzulänglichkeiten gestaltet sich die Montage von elektronischen Komponenten in Gestellen zeitlich aufwändig und ist mit einem hohen personellen Aufwand verbunden.

Die vorliegende Erfindung zielt daher darauf ab, ein Gestell mit einer Befestigungsvorrichtung bereitzustellen, mit welchem die vorgenannten Nachteile überwunden werden können.

Zur Lösung der erfindungsgemäßen Aufgabe sieht die Erfindung ein Gestell gemäß Anspruch 1 vor, bei dem ein sicheres Abstützen der elektronischen Komponente an den Befestigungsvorrichtungen dadurch erreicht wird, dass die Platte ein in Richtung der Biegeline wirksames Formschlusselement aufweist, welches mit der Komponente in formschlüssigen Eingriff bringbar ist, um die Komponente gegen die Schwerkraft abzustützen.

Die Formulierung "in Richtung der Biegelinie wirksam" ist hierbei dahingehend zu verstehen, dass die Komponente derart im Gestell aufgenommen ist, dass sich diese nicht in Richtung des Bodens, auf welchem das Gestell steht, bewegen kann, d.h. vor einem Herunterfallen bzw. Durchhängen geschützt ist.

Erfindungsgemäß ist dementsprechend vorgesehen, dass die Platte der Befestigungsvorrichtung der Seitenwand der elektronischen Komponente zugewandt ist und der zumindest eine erste Befestigungsbolzen des Befestigungsabschnitts die Befestigungslasche der elektronischen Komponente und ggf. die Lochreihe durchsetzt, was ein Abstützen der elektronischen Komponente und eine damit einhergehende vereinfachte Montage ermöglicht. Hierbei können eine oder bevorzugt zwei Befestigungsvorrichtungen vorab am jeweiligen Blechwinkel befestigt oder darin eingehängt werden und die elektronische Komponente danach an der bzw. den Befestigungsvorrichtungen abgestützt werden, sodass für die nachfolgende Montage von Schrauben oder dgl. Bereits eine abgestützte Position der Komponenten gewährleistet ist. Es ist somit nicht mehr erforderlich, die Komponente für deren Montage gleichzeitig händisch zu stützen und an den Blechwinkeln zu befestigen.

Bevorzugt ist der zumindest eine erste Befestigungsbolzen als Gewindebolzen ausgeführt.

Da die Lochreihe des Gestells senkrecht verläuft, ist bevorzugt vorgesehen, dass der Befestigungsabschnitt der Befestigungsvorrichtung in einem rechten Winkel zur Platte verläuft. So wird erreicht, dass der Befestigungsabschnitt plan an der Lochreihe des Gestells aufliegt.

Die Befestigungsvorrichtung ist bevorzugt dahingehend weitergebildet, dass der Befestigungsabschnitt zwei sich von der Platte weg erstreckende, jeweils in ein Loch der Befestigungslasche und ggf. der Lochreihe einführbare erste Befestigungsbolzen aufweist.

Das Vorsehen zweier Bolzen ermöglicht im Vergleich zu einer Ausführungsform mit lediglich einem Bolzen eine stabilere Fixierung der elektronischen Komponente im Gestell, da die beiden Bolzen des Befestigungsabschnitts in zwei Löcher - anstatt nur in ein Loch - der Lochreihe des Gestells eingreifen. Das Eigengewicht der elektronischen Komponente übt hierbei ein Kippmoment auf die Befestigungsbolzen aus, was bei geeigneter Auslegung zu einem Verkeilen der ersten Befestigungsbolzen in den Löchern der Lochreihe des Gestells führt, sodass die elektronische Komponente auch ohne weitere Verbindungselemente am Gestell gegen ein Herabfallen gesichert ist.

Um die Befestigungsvorrichtung auch bei sog. "Threaded-hole Racks", d.h. bei erfindungsgemäßen Gestellen mit Gewinde aufweisenden Löchern nutzbar zu machen, ist bevorzugt vorgesehen, dass der Befestigungsabschnitt ein Durchgangsloch für einen den Befestigungsabschnitt mit der Lochreihe verbindenden Schraubbolzen aufweist.

Weiters ist im Falle dieser bevorzugten Ausführungsform bevorzugt vorgesehen, dass der Befestigungsabschnitt wenigstens einen sich von der Platte weg erstreckenden und dem wenigsten einen ersten Befestigungsbolzen abgewandten zweiten Befestigungsbolzen aufweist.

Ist die oben beschriebene bevorzugte Ausführungsform der Befestigungsvorrichtung an einer Lochreihe eines Gestells befestigt, durchgreift der zweite Befestigungsbolzen von vorne, d.h. von der Außenseite des Gestells kommend, ein Loch der Lochreihe und sorgt so für die gewünschte Fixierung und Abstützung der auf die ersten Befestigungsbolzen aufgesetzten elektronischen Komponente.

Bevorzugt ist vorgesehen, dass der Befestigungsabschnitt zwei sich von der Platte weg erstreckende, jeweils in ein Loch der Lochreihe einführbare zweite Befestigungsbolzen aufweist, zwischen denen das Durchgangsloch angeordnet ist.

In vorteilhafter Weise ist die Befestigungsvorrichtung dahingehend weitergebildet, dass die Platte mit einer langen und einer kurzen Seite, insbesondere rechteckig, ausgebildet ist, wobei der Befestigungsabschnitt an der kurzen Seite umgebogen ist und an der langen Seite ein das Formschlusselement ausbildender Halteabschnitt umgebogen ist, auf dem die Komponente abstützbar ist, wobei vorzugsweise der Halteabschnitt ausgehend von der Plattenebene in eine dem Befestigungsabschnitt entgegengesetzte Richtung umgebogen ist.

Entsprechend dieser bevorzugten Ausführungsform liegen die Seitenbereiche der elektronischen Komponente mit ihrer Unterseite formschlüssig auf dem jeweiligen Haltabschnitt auf, wodurch eine stabile Abstützung der Komponente innerhalb des Gestells ermöglicht und die Montage der Komponente signifikant erleichtert wird.

Ein Durchhängen schwerer elektronischer Komponenten in eine unterhalb der Befestigungsebene liegende Höheneinheit kann so sowohl während des Montagevorganges, als auch danach effektiv verhindert werden.

Ein weiterer Vorteil dieser bevorzugten Ausführungsform liegt darin, dass elektronische Komponenten, die keine gesonderte Vorrichtung für eine Montage an den vorderen und ggf. hinteren 19 Zoll Blechwinkeln des Gestells aufweisen, wie z.B. ein Server mit lediglich seitlich befestigten Serverschienen, platzsparend befestigt werden können.

Gemäß einer alternativen Ausbildung ist bevorzugt vorgesehen, dass das Formschlusselement von einem hakenartig umgebogenen Endbereich der Platte gebildet ist.

Auch diese alternative Ausführungsform stellt eine stabile Befestigungsmöglichkeit für elektronische Komponenten in Gestellen bereit, mittels welcher ein Durchhängen verhindert und die Montage wesentlich vereinfacht wird.

Die Erfindung betrifft somit ein Gestell zur Aufbewahrung von elektronischen Komponenten, umfassend wenigstens zwei in Abstand voneinander angeordnete, senkrecht verlaufende und eine Lochreihe aufweisende Blechwinkel, deren zueinander weisende erste Schenkel eine Öffnung begrenzen und an denen wenigstens eine elektronische Komponente befestigt ist, wobei die elektronische Komponente im Wesentlichen eine der Öffnung entsprechende Breite und wenigstens zwei an einer Vorderseite an ihren Rändern nach außen vorspringende, mit der Vorderseite vorzugsweise fluchtende Befestigungslaschen aufweist, welche an den ersten Schenkeln anliegend angeordnet sind und mit Löchern der Lochreihe fluchtende Löcher aufweisen, und wobei am ersten Schenkel jeweils eine vorstehend erläuterte Befestigungsvorrichtung befestigt ist, deren erste Befestigungsbolzen die Löcher der Befestigungslasche und ggf. der Lochreihe durchsetzen und an denen die Komponente formschlüssig gegen die Schwerkraft abgestützt ist.

Dabei handelt es sich beim ersten Schenkel des jeweiligen Blechwinkels des Gestells um jene Schenkel, an denen die Befestigungslaschen der elektronischen Komponenten befestigt werden und die in der Regel in einer gemeinsamen vorderen Ebene liegen.

Die Befestigungslaschen der Komponente liegen hierbei auf der Vorderseite, d.h. der dem Inneren des Gestells abgewandten Seite, der Lochreihe auf und können so von den auf der Befestigungsvorrichtung angeordneten ersten Befestigungsbolzen, welche die Löcher von hinten durchsetzen, gehalten werden, wodurch eine Fixierung der Komponente am Gestell erreicht wird.

Bevorzugt ist das erfindungsgemäße Gestell derart ausgebildet, dass der Befestigungsabschnitt der Befestigungsvorrichtung an der Innenseite des Blechwinkels des Gestells am ersten Schenkel angeordnet ist.

Diese Anordnung wird gewählt, wenn die Befestigungsvorrichtung an sog. "Round-hole" bzw. "Square-hole" Racks, d.h. Gestellen mit runden bzw. quadratischen Löchern, zum Einsatz gelangt.

Alternativ kann vorgesehen sein, dass der Befestigungsabschnitt an der Außenseite des Blechwinkels am ersten Schenkel angeordnet ist.

Diese Anordnung gelangt zum Einsatz, wenn die Befestigungsvorrichtung an sog. "Threaded-hole Racks", d.h. Gestellen mit Gewinde aufweisenden Löchern befestigt wird.

Im Falle der Fixierung an einem "Threaded-hole Rack" ist bevorzugt vorgesehen, dass die zweiten Befestigungsbolzen Löcher der Lochreihe durchsetzen, wobei das zwischen den zweiten Befestigungsbolzen angeordnete Durchgangsloch mit einem Loch der Lochreihe fluchtend angeordnet ist und von einem den Befestigungsabschnitt mit der Lochreihe verbindenden Schraubbolzen durchsetzt wird.

Durch den Schraubbolzen wird die gewünschte Arretierung und Fixierung der elektronischen Komponente im Gestell erreicht.

Um eine möglichst flächige Abstützung zu ermöglichen, ist besonders bevorzugt vorgesehen, dass die Komponente auf dem Halteabschnitt aufliegt.

Alternativ kann vorgesehen sein, dass der hakenartig umgebogene Endbereich in eine schlitzförmige Ausnehmung der Komponente eingreift, wodurch eine stabile formschlüssige Verbindung zwischen dem Endbereich und der Ausnehmung sichergestellt wird.

Das Gestell weist besonders bevorzugt vier einen quaderförmigen Aufbewahrungsraum begrenzende Blechwinkel auf und die Befestigungsvorrichtungen bildet keine durchgehende Verbindung zwischen zwei benachbarten Blechwinkeln aus.

Jeweils zwei der vier den quaderförmigen Aufbewahrungsraum begrenzenden Blechwinkel bilden die Vorder- bzw. die Rückseite des Gestells.

Entsprechend dieser bevorzugten Ausführungsform ragt die an der Vorder- bzw. Hinterseite der Lochreihe befestigte Befestigungsvorrichtung in das Innere des quaderförmigen Aufbewahrungsraumes, d.h. erstreckt sich in Richtung eines zweiten Schenkels des Blechwinkels des Gestells.

Das den zumindest einen ersten Befestigungsbolzen aufweisende Ende der Befestigungsvorrichtung ist hierbei an der Vorder- bzw. Hinterseite der Lochreihe angeordnet und der Befestigungsbolzen durchsetzt von hinten ein Loch der Befestigungslasche (im Falle der an der Vorderseite angeordneten Ausführungsform) und von hinten ein Loch der Befestigungslasche sowie der Lochreihe (im Falle der an der Hinterseite angeordneten Ausführungsform).

Dies ermöglicht eine stabile Befestigung einer elektronischen Komponente in einem Gestell, ohne dass - wie im Stand der Technik vorgesehen - eine Verbindung zwischen zwei benachbarten Blechwinkeln vonnöten wäre.

Die Erfindung wird nachfolgend anhand von in der Zeichnung schematisch dargestellten Ausführungsbeispielen näher erläutert. In dieser zeigt Fig. 1 eine erste Ausführungsform der Befestigungsvorrichtung,Fig.2 eine zweite Ausführungsform der Befestigungsvorrichtung, Fig.3 die Anbringung der ersten Ausführungsform in Kombination mit einer elektronischen Komponente an der Lochreihe eines erfindungsgemäßen Gestells, Fig.4 die Anbringung der zweiten Ausführungsform in Kombination mit einer elektronischen Komponente an der Lochreihe eines erfindungsgemäßen Gestells, Fig.5 eine abgewandelte Ausführung der Anbringung der ersten Ausführungsform in Kombination mit einer elektronischen Komponente an der Lochreihe eines erfindungsgemäßen Gestells und Fig.6 eine abgewandelte Ausführung der Anbringung der zweiten Ausführungsform in Kombination mit einer elektronischen Komponente.

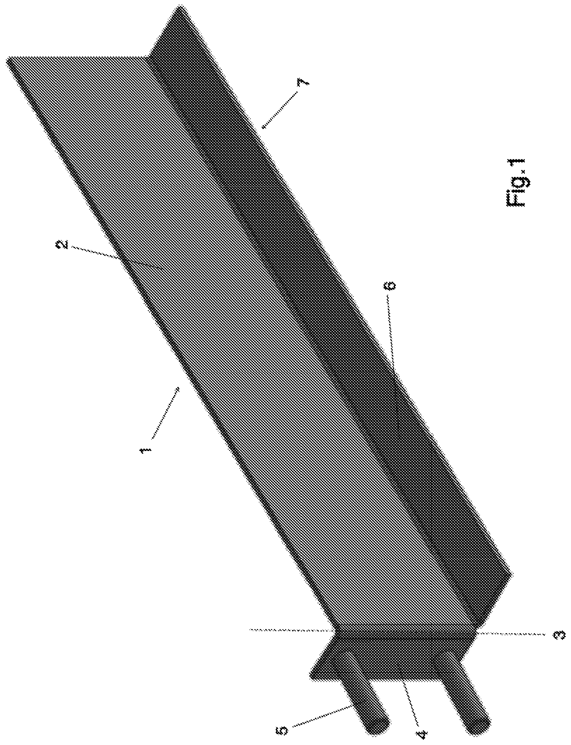

In Fig. 1 ist die Befestigungsvorrichtung mit 1 bezeichnet. Die Befestigungsvorrichtung 1 umfasst eine Platte 2, welche einen entlang einer Biegelinie 3 umgebogenen Befestigungsabschnitt 4 mit zwei sich von der Platte 2 weg erstreckenden ersten Befestigungsbolzen 5 aufweist. Der Befestigungsabschnitt 4 verläuft hierbei in einem rechten Winkel zur Platte 2.

Die Platte 2 weist ein in Richtung der Biegeline 3 wirksames Formschlusselement 6 auf, auf das eine elektronische Komponente (in Fig.1 nicht gezeigt) auflegbar ist, um die Komponente gegen die Schwerkraft abzustützen.

Die Platte 2 hat eine lange Seite und eine kurze Seite und ist rechteckig ausgebildet, wobei der Befestigungsabschnitt 4 an der kurzen Seite umgebogen ist und an der langen Seite ein das Formschlusselement 6 ausbildender Halteabschnitt 7 umgebogen ist. Der Halteabschnitt 7 ist ausgehend von der Plattenebene in eine dem Befestigungsabschnitt 4 entgegengesetzte Richtung im rechten Winkel umgebogen.

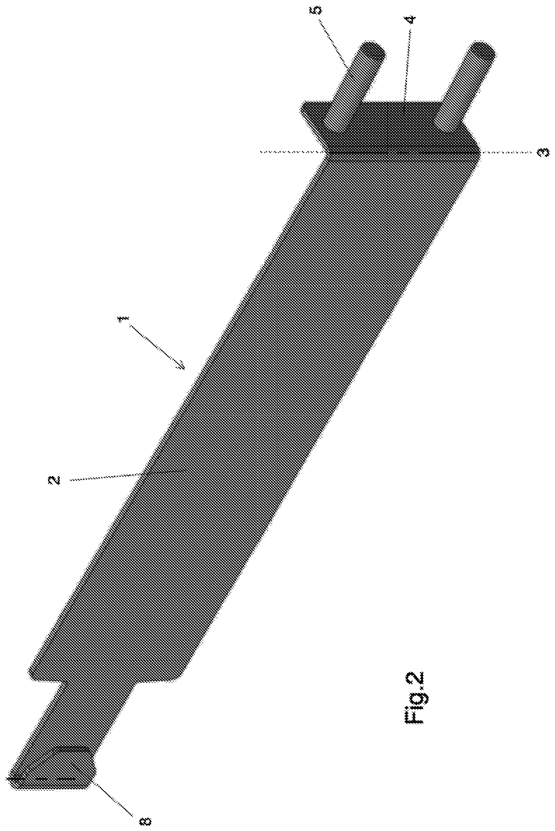

Fig.2 zeigt eine zweite Ausführungsform der Erfindung, wobei gleiche Teile mit den gleichen Bezugszeichen versehen sind wie in Fig. 1.

Im Unterschied zu der in Fig.1 gezeigten Ausführungsform, wird das in Fig.1 gezeigte Formschlusselement 6 in Fig.2 von einem hakenartig umgebogenen Endbereich 8 der Platte 2 gebildet.

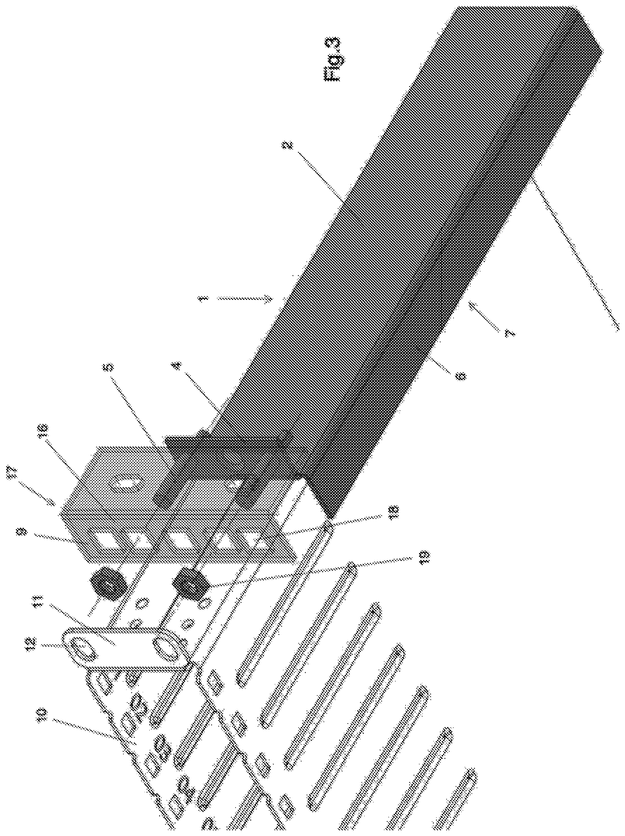

Fig.3 zeigt die in Fig.1 gezeigte erste Ausführungsform der Befestigungsvorrichtung 1 in Kombination mit einer Lochreihe 9 an einem ersten Schenkel 16 eines Blechwinkels 17 eines erfindungsgemäßen Gestells und einer am Gestell zu befestigenden elektronischen Komponente 10.

Die elektronische Komponente 10 ist beiderseits mit Befestigungslaschen 11 mit jeweils zwei Löchern 12 ausgestattet, welche im montierten Zustand mit den Löchern 18 der Vorderseite der Lochreihe 9 des Gestells fluchten.

Ist die elektronische Komponente 10 an der Lochreihe 9 befestigt, durchsetzen die ersten Befestigungsbolzen 5 der Befestigungsvorrichtung 1 sowohl die Löcher 12 der Befestigungslasche 11 als auch die Löcher 18 der Lochreihe 9, wobei durch Festziehen der auf ein Gewinde an den ersten Befestigungsbolzen 5 aufgeschraubten Muttern 19 der erste Schenkel 16 zwischen der Befestigungslasche 11 und dem Befestigungsabschnitt 4 der Vorrichtung 1 eingeklemmt wird. Die elektronische Komponente 10 liegt hierbei auf dem Halteabschnitt 7 auf. Hierdurch wird erreicht, dass die Komponente 10 formschlüssig gegen die Schwerkraft abgestützt und sicher im Gestell befestigt ist.

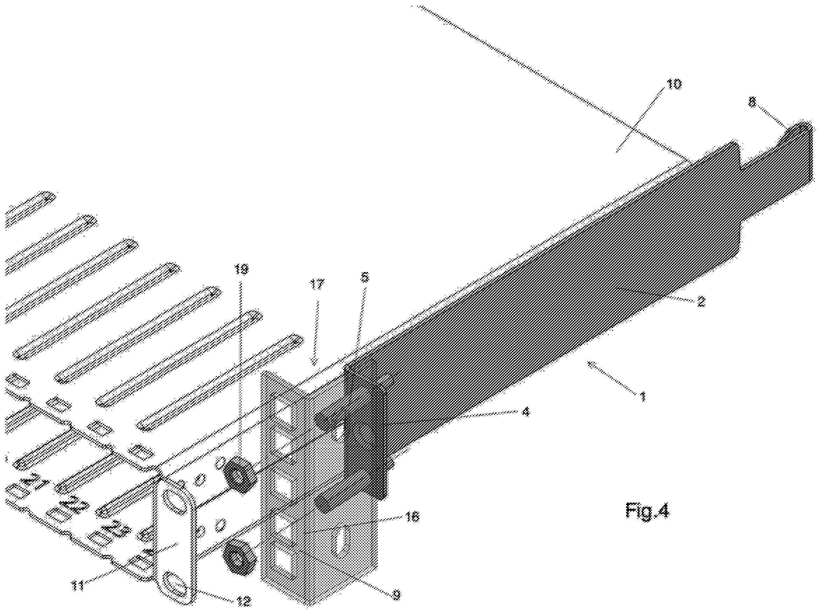

Fig.4 zeigt die in Fig.2 gezeigte zweite Ausführungsform der Befestigungsvorrichtung 1 in Kombination mit einer Lochreihe 9 eines erfindungsgemäßen Gestells und einer im Gestell zu befestigenden elektronischen Komponente 10.

Im Unterschied zur ersten Ausführungsform findet die Abstützung der elektronischen Komponente 10 mittels Einrastens in einen hakenartig umgebogenen Endbereich 8 der Platte 2 statt.

Die elektronische Komponente 10 besitzt in diesem Fall ein zum umgebogenen Endbereich 8 passendes Gegenstück, z.B. eine schlitzförmige Ausnehmung, in welche der Endbereich 8 eingreift.

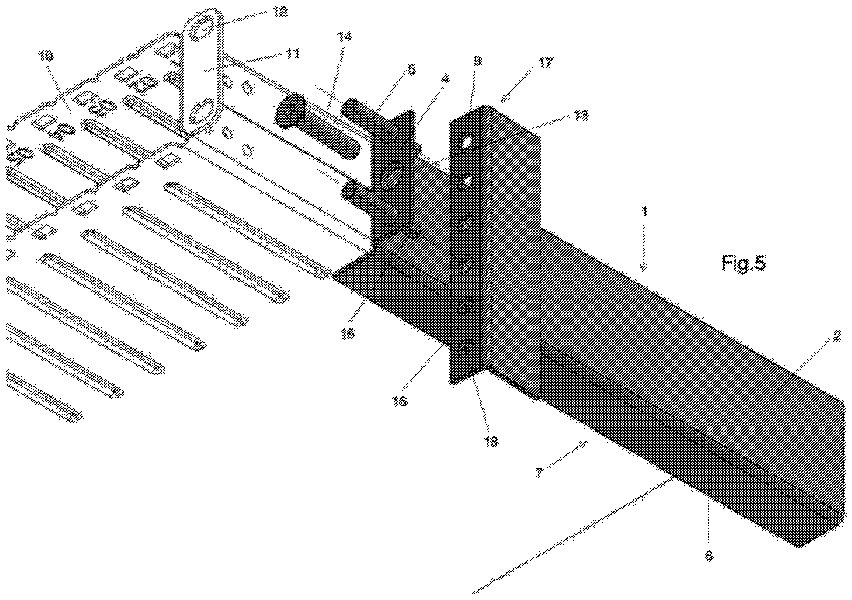

Fig.5 zeigt eine abgewandelte Ausführungsform der Befestigung der Befestigungsvorrichtung 1 an der Lochreihe 9 eines erfindungsgemäßen Gestells. Im Falle dieser Ausführungsform handelt es sich bei dem Gestell, in welchem die elektronische Komponente 10 zu befestigen ist, um ein sog. "Threaded-hole Rack".

Der Befestigungsabschnitt 4 ist in diesem Fall mit einem Durchgangsloch 13 versehen, durch welches ein Schraubbolzen 14 geschraubt wird, wenn der Befestigungsabschnitt 4 mit der Lochreihe 9 des Gestells verbunden werden soll.

Weiters ist im Falle dieser bevorzugten Ausführungsform vorgesehen, dass der Befestigungsabschnitt 4 zwei sich von der Platte weg erstreckende und den beiden ersten Befestigungsbolzen 5 abgewandte zweite Befestigungsbolzen 15 aufweist.

Im an die Lochreihe 9 befestigten Zustand durchgreifen die zweiten Befestigungsbolzen 15 der Befestigungsvorrichtung 1 die Löcher 18 der Lochreihe 9 von vorne, d.h. von der Außenseite des Gestells kommend, und sorgen so für die gewünschte Abstützung der Befestigungsvorrichtung 1, sowie der ebenfalls von vorne auf die ersten Befestigungsbolzen 5 aufgesetzten Befestigungslasche 11 der elektronischen Komponente 10. Die ersten Befestigungsbolzen 5 durchsetzen hierbei die Löcher 12 der Befestigungslasche 11 und der Befestigungsabschnitt 4 ist zwischen der Befestigungslasche 11 und der Lochreihe 9 angeordnet.

Durch Festziehen des im Durchgangsloch 13 des Befestigungsabschnitts 4 befindlichen Schraubbolzens 14 wird eine Fixierung der Befestigungsvorrichtung 1 an der Lochreihe 9 erreicht. Die von vorne auf die ersten Befestigungsbolzen 5 aufgesetzte elektronische Komponente 10 wird durch Festziehen von in Fig.5 nicht gezeigten, auf ein Gewinde an den ersten Befestigungsbolzen 5 aufschraubbaren Muttern 19 an der Befestigungsvorrichtung 1 und der Lochreihe 9 fixiert.

Analog zur in Fig.1 und Fig.3 gezeigten Ausführungsform findet die Abstützung der elektronischen Komponente 10 mittels des Formschlusselements 6 statt, auf welchem die Komponente 10 aufliegt.

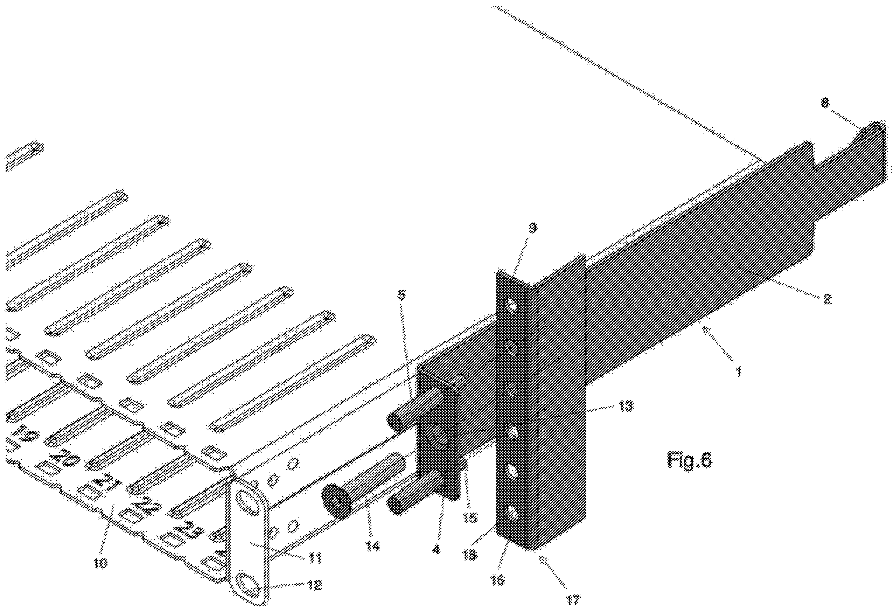

Fig.6 zeigt die Befestigung gemäß Fig.5 im Falle der erfindungsgemäßen Befestigungsvorrichtung 1 gemäß Fig.2.

Analog zur Ausführungsform gemäß Fig.4 findet die Abstützung der elektronischen Komponente 10 mittels Einrastens in einen hakenartig umgebogenen Endbereich 8 der Platte 2 statt.

## Patentansprüche

1. Gestell zur Aufbewahrung von elektronischen Komponenten (10), umfassend wenigstens zwei in Abstand voneinander angeordnete, senkrecht verlaufende und eine Lochreihe (9) aufweisende Blechwinkel, deren zueinander weisende erste Schenkel eine Öffnung begrenzen und an denen wenigstens eine elektronische Komponente (10) befestigt ist, wobei die elektronische Komponente (10) im Wesentlichen eine der Öffnung entsprechende Breite und wenigstens zwei an einer Vorderseite an ihren Rändern nach außen vorspringende, mit der Vorderseite vorzugsweise fluchtende Befestigungslaschen (11) aufweist, welche an den ersten Schenkeln anliegend angeordnet sind und mit Löchern der Lochreihe (9) fluchtende Löcher (12) aufweisen, und wobei an den ersten Schenkeln jeweils eine Befestigungsvorrichtung (1) befestigt ist mit einer an eine Seitenwand der Komponente anlegbaren und ggf. mit dieser verbindbaren Platte (2), welche einen entlang einer Biegelinie (3) umgebogenen Befestigungsabschnitt (4) aufweist, welcher wenigstens einen sich von der Platte (2) weg erstreckenden, das Loch (12) der Befestigungslasche (11) und ggf. der Lochreihe (9) durchsetzenden ersten Befestigungsbolzen (5) aufweist, und wobei die Komponente (10) an den Befestigungsvorrichtungen (1) formschlüssig gegen die Schwerkraft abgestützt ist, wobei die Platte (2) ein in Richtung der Biegeline (3) wirksames Formschlusselement (6) aufweist, welches mit der Komponente (10) in formschlüssigen Eingriff bringbar ist, um die Komponente (10) gegen die Schwerkraft abzustützen.

2. Gestell nach Anspruch 1, **dadurch gekennzeichnet, dass** der Befestigungsabschnitt (4) in einem rechten Winkel zur Platte (2) verläuft.

3. Gestell nach Anspruch 1 oder 2, **dadurch gekennzeichnet, dass** der Befestigungsabschnitt (4) zwei sich von der Platte (2) weg erstreckende, jeweils ein Loch (12) der Befestigungslasche (11) und ggf. der Lochreihe (9) durchsetzende erste Befestigungsbolzen (5) aufweist.

4. Gestell nach Anspruch 1, 2 oder 3, **dadurch gekennzeichnet, dass** der Befestigungsabschnitt (4) ein Durchgangsloch (13) für einen den Befestigungsabschnitt (4) mit der Lochreihe (9) verbindenden Schraubbolzen (14) aufweist.

5. Gestell nach Anspruch 4, **dadurch gekennzeichnet, dass** der Befestigungsabschnitt (4) wenigstens einen sich von der Platte (2) weg erstreckenden und dem wenigsten einen ersten Befestigungsbolzen (5) bezüglich des Befestigungsabschnitts (4) gegenüberliegenden zweiten Befestigungsbolzen (15) aufweist.

6. Gestell nach Anspruch 5, **dadurch gekennzeichnet, dass** der Befestigungsabschnitt (4) zwei sich von der Platte (2) weg erstreckende, jeweils in ein Loch der Lochreihe (9) einführbare zweite Befestigungsbolzen (15) aufweist, zwischen denen das Durchgangsloch (13) angeordnet ist.

7. Gestell nach einem der Ansprüche 1 bis 6, **dadurch gekennzeichnet, dass** die Platte (2) mit einer langen und einer kurzen Seite, insbesondere rechteckig, ausgebildet ist, wobei der Befestigungsabschnitt (4) an der kurzen Seite umgebogen ist und an der langen Seite ein das Formschlusselement (6) ausbildender Halteabschnitt (7) umgebogen ist, auf dem die Komponente (10) abstützbar ist, wobei vorzugsweise der Halteabschnitt (7) ausgehend von der Plattenebene in eine dem Befestigungsabschnitt (4) entgegengesetzte Richtung umgebogen ist.

8. Gestell nach einem der Ansprüche 1 bis 6, **dadurch gekennzeichnet, dass** das Formschlusselement (6) von einem hakenartig umgebogenen Endbereich der Platte (2) gebildet ist.

9. Gestell nach einem der Ansprüche 1 bis 8, **dadurch gekennzeichnet, dass** der Befestigungsabschnitt (4) an der Innenseite des Blechwinkels am ersten Schenkel angeordnet ist.

10. Gestell nach einem der Ansprüche1 bis 8, **dadurch gekennzeichnet, dass** der Befestigungsabschnitt (4) an der Außenseite des Blechwinkels am ersten Schenkel angeordnet ist.

11. Gestell nach Anspruch 5, **dadurch gekennzeichnet, dass** die zweiten Befestigungsbolzen (15) Löcher der Lochreihe (9) durchsetzen, wobei das zwischen den zweiten Befestigungsbolzen (15) angeordnete Durchgangsloch (13) mit einem Loch der Lochreihe (9) fluchtend angeordnet ist und von einem den Befestigungsabschnitt (4) mit der Lochreihe (9) verbindenden Schraubbolzen (14) durchsetzt wird.

12. Gestell nach Anspruch 7, **dadurch gekennzeichnet, dass** die Komponente (10) auf dem Halteabschnitt (7) aufliegt.

13. Gestell nach Anspruch 8, **dadurch gekennzeichnet, dass** der hakenartig umgebogene Endbereich (8) in eine schlitzförmige Ausnehmung der Komponente (10) eingreift.

14. Gestell nach einem der Ansprüche 1 bis 13, **dadurch gekennzeichnet, dass** das Gestell vier einen quaderförmigen Aufbewahrungsraum begrenzende Blechwinkel aufweist und die Befestigungsvorrichtungen (1) keine durchgehende Verbindung zwischen zwei benachbarten Blechwinkeln ausbilden.

## Claims

1. A rack for storing electronic components (10), comprising at least two sheet metal angles arranged spaced apart from each other, extending vertically and having a row of holes (9), whose mutually facing first legs delimit an opening and to which at least one electronic component (10) is fastened, wherein the electronic component (10) has a width substantially corresponding to the opening and, on a front side at edges thereof, at least two fastening tabs (11) projecting outwards and preferably flush with the front side, which are arranged resting against the first legs and have holes (12) aligned with holes of the row of holes (9), and wherein a fastening device (1) is fastened to each of the first legs, having a plate (2) which can be placed against a side wall of the component and optionally connected thereto, which plate has a fastening portion (4) bent along a bend line (3), which fastening portion has at least one first fastening bolt (5) extending away from the plate (2) and passing through the hole (12) of the fastening tab (11) and optionally of the row of holes (9), and wherein the component (10) is supported on the fastening devices (1) in a positive-locking manner against gravity, wherein the plate (2) has a positive-locking element (6) effective in the direction of the bend line (3), which positive-locking element can be brought into positive-locking engagement with the component (10) in order to support the component (10) against gravity.

2. The rack according to claim 1, **characterized in that** the fastening portion (4) extends at a right angle to the plate (2).

3. The rack according to claim 1 or 2, **characterized in that** the fastening portion (4) has two first fastening bolts (5) extending away from the plate (2), each passing through a hole (12) of the fastening tab (11) and optionally of the row of holes (9).

4. The rack according to claim 1, 2, or 3, **characterized in that** the fastening portion (4) has a through hole (13) for a screw bolt (14) connecting the fastening portion (4) to the row of holes (9).

5. The rack according to claim 4, **characterized in that** the fastening portion (4) has at least one second fastening bolt (15) extending away from the plate (2) and opposite the at least one first fastening bolt (5) with respect to the fastening portion (4).

6. The rack according to claim 5, **characterized in that** the fastening portion (4) has two second fastening bolts (15) extending away from the plate (2) and insertable into a respective hole of the row of holes (9), between which second fastening bolts the through hole (13) is arranged.

7. The rack according to any one of claims 1 to 6, **characterized in that** the plate (2) is formed with a long side and a short side, in particular rectangular, wherein the fastening portion (4) is bent on the short side and a holding portion (7) forming the positive-locking element (6) is bent on the long side, on which holding portion the component (10) can be supported, wherein preferably the holding portion (7), starting from the plate plane, is bent in a direction opposite to the fastening portion (4).

8. The rack according to any one of claims 1 to 6, **characterized in that** the positive-locking element (6) is formed by a hook-like bent end region of the plate (2).

9. The rack according to any one of claims 1 to 8, **characterized in that** the fastening portion (4) is arranged on the inner side of the sheet metal angle on the first leg.

10. The rack according to any one of claims 1 to 8, **characterized in that** the fastening portion (4) is arranged on the outer side of the sheet metal angle on the first leg.

11. The rack according to claim 5, **characterized in that** the second fastening bolts (15) pass through holes of the row of holes (9), wherein the through hole (13) arranged between the second fastening bolts (15) is arranged aligned with a hole of the row of holes (9) and is passed through by a screw bolt (14) connecting the fastening portion (4) to the row of holes (9).

12. The rack according to claim 7, **characterized in that** the component (10) rests on the holding portion (7).

13. The rack according to claim 8, **characterized in that** the hook-like bent end region (8) engages in a slot-shaped recess of the component (10).

14. The rack according to any one of claims 1 to 13, **characterized in that** the rack has four sheet metal angles delimiting a cuboid storage space, and the fastening devices (1) do not form a continuous connection between two adjacent sheet metal angles.

## Revendications

1. Bâti pour le stockage de composants électroniques (10), comprenant au moins deux cornières en tôle disposées à distance l'une de l'autre, s'étendant verticalement et présentant une rangée de trous (9), dont des premières ailes tournées l'une vers l'autre délimitent une ouverture et auxquelles est fixé au moins un composant électronique (10), dans lequel le composant électronique (10) présente sensiblement une largeur correspondant à l'ouverture et au moins deux pattes de fixation (11) faisant saillie vers l'extérieur sur une face avant au niveau de ses bords, de préférence en alignement avec la face avant, lesquelles sont disposées en appui contre les premières ailes et présentent des trous (12) alignés avec des trous de la rangée de trous (9), et dans lequel un dispositif de fixation (1) respectif est fixé aux premières ailes avec une plaque (2) pouvant être appliquée contre une paroi latérale du composant et le cas échéant reliée à celle-ci, laquelle plaque présente une partie de fixation (4) repliée le long d'une ligne de pliage (3), laquelle partie de fixation présente au moins un premier boulon de fixation (5) s'étendant à l'opposé de la plaque (2) et traversant le trou (12) de la patte de fixation (11) et le cas échéant de la rangée de trous (9), et dans lequel le composant (10) est supporté par complémentarité de forme contre la gravité sur les dispositifs de fixation (1), la plaque (2) présentant un élément à complémentarité de forme (6) agissant dans la direction de la ligne de pliage (3), lequel peut être amené en prise par complémentarité de forme avec le composant (10) afin de supporter le composant (10) contre la gravité.

2. Bâti selon la revendication 1, **caractérisé en ce que** la partie de fixation (4) s'étend à angle droit par rapport à la plaque (2).

3. Bâti selon la revendication 1 ou 2, **caractérisé en ce que** la partie de fixation (4) présente deux premiers boulons de fixation (5) s'étendant à l'opposé de la plaque (2), traversant chacun un trou (12) de la patte de fixation (11) et le cas échéant de la rangée de trous (9).

4. Bâti selon la revendication 1, 2 ou 3, **caractérisé en ce que** la partie de fixation (4) présente un trou traversant (13) pour un boulon fileté (14) reliant la partie de fixation (4) à la rangée de trous (9).

5. Bâti selon la revendication 4, **caractérisé en ce que** la partie de fixation (4) présente au moins un deuxième boulon de fixation (15) s'étendant à l'opposé de la plaque (2) et opposé audit au moins un premier boulon de fixation (5) par rapport à la partie de fixation (4).

6. Bâti selon la revendication 5, **caractérisé en ce que** la partie de fixation (4) présente deux deuxièmes boulons de fixation (15) s'étendant à l'opposé de la plaque (2), pouvant chacun être inséré dans un trou de la rangée de trous (9), entre lesquels le trou traversant (13) est disposé.

7. Bâti selon l'une des revendications 1 à 6, **caractérisé en ce que** la plaque (2) est réalisée avec un côté long et un côté court, en particulier rectangulaire, la partie de fixation (4) étant repliée sur le côté court et une partie de maintien (7) formant l'élément à complémentarité de forme (6) étant repliée sur le côté long, sur laquelle le composant (10) peut être supporté, la partie de maintien (7) étant de préférence repliée, en partant du plan de la plaque, dans une direction opposée à la partie de fixation (4).

8. Bâti selon l'une des revendications 1 à 6, **caractérisé en ce que** l'élément à complémentarité de forme (6) est formé par une zone d'extrémité de la plaque (2) repliée en forme de crochet.

9. Bâti selon l'une des revendications 1 à 8, **caractérisé en ce que** la partie de fixation (4) est disposée sur la face intérieure de la cornière en tôle sur la première aile.

10. Bâti selon l'une des revendications 1 à 8, **caractérisé en ce que** la partie de fixation (4) est disposée sur la face extérieure de la cornière en tôle sur la première aile.

11. Bâti selon la revendication 5, **caractérisé en ce que** les deuxièmes boulons de fixation (15) traversent des trous de la rangée de trous (9), le trou traversant (13) disposé entre les deuxièmes boulons de fixation (15) étant disposé en alignement avec un trou de la rangée de trous (9) et étant traversé par un boulon fileté (14) reliant la partie de fixation (4) à la rangée de trous (9).

12. Bâti selon la revendication 7, **caractérisé en ce que** le composant (10) repose sur la partie de maintien (7).

13. Bâti selon la revendication 8, **caractérisé en ce que** la zone d'extrémité (8) repliée en forme de crochet s'engage dans un évidement en forme de fente du composant (10).

14. Bâti selon l'une des revendications 1 à 13, **caractérisé en ce que** le bâti présente quatre cornières en tôle délimitant un espace de stockage parallélépipédique et les dispositifs de fixation (1) ne forment pas de liaison continue entre deux cornières en tôle adjacentes.
